# EUROPÄISCHE PATENTSCHRIFT

(11) **EP 2 770 597 B1**
(45) Veröffentlichungstag und Bekanntmachung des Hinweises auf die Patenterteilung: **21.12.2016**
(21) Anmeldenummer: 13155926.2
(22) Anmeldetag: 20.02.2013
(51) Int. Cl.: H02H 3/00, G01R 31/327, H02H 3/04, H02H 7/26, G01R 31/40, H02H 1/00

(54) **Verfahren zum Prüfen mehrerer räumlich verteilter Schutzeinrichtungen eines Energieversorgungsnetzes sowie entsprechendes Prüfsystem**
Method for testing a plurality of spatially distributed protection devices of an energy supply network and corresponding testing system
Procédé de contrôle de plusieurs dispositifs de protection divisés dans l'espace d'un réseau d'alimentation d'énergie, ainsi que le système de contrôle correspondant

(43) Veröffentlichungstag der Anmeldung: 27.08.2014
(73) Patentinhaber: Omicron electronics GmbH, 6833 Klaus (AT)
(72) Erfinder: Hensler, Thomas, 6833 Klaus (AT); Schwabe, Stefan, 10707 Berlin (DE)
(74) Vertreter: Banzer, Hans-Jörg

(56) Entgegenhaltungen:
- EP-A1- 0 935 327
- EP-A2- 0 666 629
- US-A- 5 742 513

## Beschreibung

Die vorliegende Erfindung betrifft ein Verfahren und ein Prüfsystem, um mehrere räumlich verteilte Schutzeinrichtungen, welche zum Schutz eines Energieversorgungsnetzes (z. B. eines Hochspannungsnetzes) eingesetzt sind, zu testen bzw. zu prüfen.

Die EP 0 935 327 A1 beschreibt ein Schutz- und Steuersystem für ein elektrisches Spannungssystem, wobei Schutzsteuerungen eingesetzt werden. Dabei wird ein Überwachungsprogrammmodul über ein Kommunikationsnetz an die Schutzsteuerungen gesendet. Mit dem Überwachungsprogrammmodul wird die von jeder Steuerung erfasste Strommenge überprüft, der Betriebszustand eines Relais jeder Steuerung erfasst und bewertet sowie abnormale Inhalte jeder Steuerung erfasst und bewertet. Abnormale Inhalte (von einer Steuerung) werden beispielsweise über das Überwachungsprogrammmodul zu einer anderen Steuerung übertragen. Auf diese Weise wird das Überwachungsprogrammmodul zu jeder Steuerung übertragen und an der entsprechenden Stelle ausgeführt, wobei die erfassten Ergebnisse einem Wissen sequenziell hinzugefügt werden. Das Überwachungsprogrammmodul sammelt Ergebnisse von allen Schutzsteuerungen, um diese Ergebnisse am Ende mit Hilfe einer Anzeigesteuerung betrachten zu können.

Schutzeinrichtungen für Energieversorgungsnetze umfassen ein oder mehrere Schutzgeräte, welche Prozessgrößen (z. B. Strom, Spannung, aber auch Schaltzustände von z.B. Leistungsschaltern oder Zustände von z.B. Transformatoren) des Energieversorgungsnetzes überwachen und auf Fehler analysieren. Wenn die Schutzeinrichtung durch diese Analyse einen Fehler in einem ihr zugeordneten Schutzbereich des Energieversorgungsnetzes erfasst, gibt die Schutzeinrichtung Schaltkommandos aus, um insbesondere einen Leistungsschalter anzusteuern, mit welchem der erfasste Fehler isoliert wird, indem der entsprechende Teil des Energieversorgungsnetzes abgetrennt wird. Dazu unterbricht der Leistungsschalter den Energiefluss des Energieversorgungsnetzes, indem der Leistungsschalter z.B. eine Leitung des Energieversorgungsnetzes oder den Energiefluss auf einer Seite eines Transformators unterbricht. Einige Schutzeinrichtungen bzw. Schutzgeräte sind darüber hinaus in der Lage, nach einer gewissen Pausenzeit Schaltkommandos auszugeben, um den vorher geöffneten Leistungsschalter wieder zu schließen. Wenn der Fehler beim Schließen des Leistungsschalters nicht mehr vorhanden ist, kehrt die Schutzeinrichtung bzw. das Schutzgerät zur normalen Überwachung des Energieversorgungsnetzes zurück. Sollte dagegen der Fehler beim Schließen des Leistungsschalters noch vorhanden sein, erkennt dies die Schutzeinrichtung bzw. das Schutzgerät, so dass der Leistungsschalter mittels der Schutzeinrichtung bzw. des Schutzgeräts sofort wieder geöffnet wird.

Unter einem Energieversorgungsnetz wird dabei insbesondere ein Netz verstanden, welches Leitungen umfasst, welche Spannungen von mehr als 10 kV untereinander aufweisen. Das hier gemeinte Energieversorgungsnetz umfasst zum einen Energie-Übertragungsnetze mit Spannungen von über 100 kV und zum anderen so genannte Energie-Verteilnetze mit Spannungen von über 10 kV (z.B. von 20 kV). Dabei kann es sich um eine Wechselspannung (z.B. 50 Hz) oder um eine Gleichspannung handeln. Ein Leistungsschalter ist ausgestaltet, um eine aktive elektrische Verbindung einer solchen Hochspannungsleitung zu unterbrechen. Daher kann ein Leistungsschalter hohe Überlastströme und Kurzschlussströme (bis 800 kA) schalten und muss diese für eine vorgegebene Zeitspanne halten und wieder ausschalten können.

Die Prüfung dieser Schutzeinrichtungen erfolgt nach dem Stand der Technik meist durch die Prüfung der einzelnen Schutzeinrichtung in einem isolierten Test. Der Nachweis des korrekten Systemverhaltens, d.h. des korrekten Zusammenspiels aller Komponenten (insbesondere Schutzeinrichtungen), erfolgt nach dem Stand der Technik in der Regel nicht durch eine Funktionsprüfung, sondern durch eine Revision der entsprechenden technischen Unterlagen.

Daher stellt sich die vorliegende Erfindung die Aufgabe, die Prüfung von räumlich verteilten Schutzeinrichtungen eines Energieversorgungsnetzes zu verbessern, so dass auch das korrekte Zusammenspiel der räumlich verteilten Schutzeinrichtungen mit zu diesem Zweck erzeugten Prüfsequenzen überprüft wird.

Erfindungsgemäß wird diese Aufgabe durch ein Verfahren zum Prüfen mehrerer räumlich verteilter Schutzeinrichtungen eines Energieversorgungsnetzes nach Anspruch 1, durch ein Prüfsystem zum Prüfen von mehreren an räumlich verteilten Standorten angeordneten Schutzeinrichtungen eines Energieversorgungsnetzes nach Anspruch 10, durch eine Steuereinrichtung nach Anspruch 12 und durch ein Computerprogrammprodukt nach Anspruch 13 gelöst. Die abhängigen Ansprüche definieren bevorzugte und vorteilhafte Ausführungsformen der vorliegenden Erfindung.

Im Rahmen der vorliegenden Erfindung wird ein Verfahren zum Prüfen mehrerer räumlich verteilter Schutzeinrichtungen eines Energieversorgungsnetzes bereitgestellt. Dabei ist jede dieser Schutzeinrichtungen ausgestaltet, um beim Erfassen eines Fehlers in einem von der jeweiligen Schutzeinrichtung überwachten Bereich des Energieversorgungsnetzes diesen Fehler (insbesondere durch Öffnen eines zugeordneten Leistungsschalters) zu isolieren. Dabei umfasst das erfindungsgemäße Verfahren folgende Schritte:
a) Erstellen einer initialen Prüfsequenz, mit welcher eine oder mehrere Schutzeinrichtungen getestet bzw. geprüft werden können. Dabei umfasst jede Prüfsequenz sowohl Eingaben für die zu prüfende Schutzeinrichtung in Form von Prozessgrößen des Energieversorgungsnetzes und kann auch Soll-Ausgaben (Prüfantworten), welche von der jeweils geprüften Schutzeinrichtung abhängig von den Eingaben ausgegeben werden sollen, umfassen.
b) Ausgeben bzw. Anlegen der Prüfsequenz an die Schutzeinrichtungen.
c) Erfassen der Ausgaben der geprüften Schutzeinrichtungen, wobei die jeweilige Schutzeinrichtung diese Ausgaben aufgrund der an die jeweilige Schutzeinrichtung angelegte Prüfsequenz ausgibt.
d) Analysieren der Ausgaben und Erzeugen von Eingaben für die Schutzeinrichtungen abhängig von den Ausgaben. Wenn die Ausgaben einer Schutzeinrichtung (beispielsweise ein Schaltbefehl zum Öffnen eines Leistungsschalters) zu Änderungen der Prozessgrößen anderer Schutzeinrichtungen führen, werden entsprechend dieser Ausgaben Eingaben (in Form der geänderten Prozessgrößen) für diese anderen Schutzeinrichtungen erzeugt.
   Wenn diese (neu) erzeugten Eingaben noch nicht Bestandteil der Prüfsequenz sind, wird die Prüfsequenz um die entsprechenden (neu) erzeugten Eingaben erweitert, und das Verfahren kehrt zu dem Schritt b zurück bzw. fährt mit dem Schritt b fort.
   Wenn dagegen die (neu) erzeugten Eingaben bereits Bestandteil der Prüfsequenz sind, fährt das Verfahren beim folgenden Schritt e fort.
e) Auswerten der Ausgaben der Schutzeinrichtungen. Spätestens in diesem Schritt wird überprüft, ob die im Rahmen der Prüfung von den Schutzeinrichtungen erzeugten Ausgaben den Soll-Ausgaben entsprechen, welche beispielsweise Bestandteil der Prüfsequenz sein können. Dabei legt eine Soll-Ausgaben insbesondere fest, was (beispielsweise in Form von Binärdaten) die jeweilige Schutzeinrichtung auszugeben hat und wann die jeweilige Schutzeinrichtung die Soll-Ausgabe auszugeben hat (z. B. nach einem ersten Zeitintervall und vor Beendigung eines zweiten Zeitintervalls, welche beide mit dem Anlegen der Prüfsequenz beginnen). Das Ergebnis der Auswertung aller Ausgaben der Schutzeinrichtungen ist, ob die Schutzeinrichtungen die Prüfsequenz korrekt abgearbeitet haben oder nicht.

Die Schritte b) und c) erfolgen dabei insbesondere zeitsynchron, so dass die Prüfsequenz von allen Prüfeinrichtungen zeitsynchron an die Schutzeinrichtungen angelegt wird und zeitgleiche Ausgaben denselben Zeitstempel erhalten. Dies wird durch hochgenaue Uhren in den Prüfeinrichtungen erreicht, welche z.B. mittels GPS synchronisiert werden. Dadurch können auch die Zeitpunkte, zu welchen bestimmte Ausgaben der Schutzeinrichtungen erfasst werden, bei der Analyse im Schritt d) oder bei der Auswertung im Schritt e) berücksichtigt werden.

Im Unterschied zum Stand der Technik wird vorteilhafterweise auch das Zusammenspiel verschiedener Schutzeinrichtungen überprüft, auch wenn diese Schutzeinrichtungen räumlich auseinander liegen. Dabei wird unter räumlich verteilten Schutzeinrichtungen verstanden, dass zumindest zwei dieser Schutzeinrichtungen mindestens 1 km auseinander liegen. Es ist aber auch möglich, dass zumindest zwei dieser Schutzeinrichtungen mehrere 10 km, mehrere 100 km oder auch mehrere 1000 km auseinander liegen.

Die Ausgaben der jeweiligen Schutzeinrichtung können dabei sowohl einen Schalteröffnungsbefehl, mit welchem ein Leistungsschalter geöffnet wird, als auch einen Wiedereinschaltbefehl, mit welchem der Leistungsschalter wieder geschlossen wird, umfassen.

Wenn es sich bei den Eingaben für die Schutzeinrichtungen um Ströme oder Spannungen handelt, können diese durch die Angabe von festen Amplituden, Phasenwinkeln und/oder Frequenzen definiert werden. Darüber hinaus können diese Eingaben allerdings auch in Form einer Rampe definiert werden, indem beispielsweise die Amplitude einer Spannung oder eines Stroms innerhalb von einer bestimmten Zeitspanne von einem ersten Wert auf einen zweiten Wert ansteigt oder abfällt.

Indem beim Prüfen der Schutzeinrichtungen sowohl das Öffnen als auch das Wieder-Schließen von Leistungsschaltern berücksichtigt wird, wird vorteilhafterweise das System, welches neben den räumlich verteilten zu prüfenden Schutzeinrichtungen das Energieversorgungsnetzes umfasst, in seinem Zusammenspiel geprüft. Da sich die beobachteten Schaltkommandos (für die Leistungsschalter) in den Prozessgrößen widerspiegeln, wird das Öffnen und Wieder-Schließen der Leistungsschalter vorteilhafterweise bei der erfindungsgemäßen Prüfung der Schutzeinrichtungen simuliert.

Das Erzeugen von neuen Eingaben abhängig von den erfassten Ausgaben (z.B. Schaltbefehlen) der Schutzeinrichtungen erfolgt insbesondere mit Hilfe eines Modells des von den Schutzeinrichtungen geschützten Energieversorgungsnetzes. Ausgehend von den erfassten Ausgaben werden mit Hilfe dieses Modells Änderungen der Prozessgrößen des Energieversorgungsnetzes bestimmt, aus welchen dann die Eingaben für die zu prüfenden Schutzeinrichtungen abgeleitet werden.

Durch die Verwendung des Modells des Energieversorgungsnetzes kann vorteilhafterweise das zeitliche Verhalten von Prozessgrößen des Energieversorgungsnetzes an einem ersten Standort (d.h. für eine erste Schutzeinrichtung) bestimmt bzw. simuliert werden, wenn an einem zweiten Standort (beispielsweise durch einen Schaltbefehl einer zweiten Schutzeinrichtung) ein Leistungsschalter geschlossen wird. Mit anderen Worten können durch das Modell des Energieversorgungsnetzes die Auswirkungen von Ausgaben (z. B. Schaltbefehlen) der zweiten Schutzeinrichtung auf die von der ersten Schutzeinrichtung erfassten Prozessgrößen simuliert werden, auch wenn die beiden Schutzeinrichtungen viele Kilometer auseinander liegen.

Erfindungsgemäß kann es sich bei diesem Modell um ein statisches, um ein dynamisches oder um ein transientes Modell handeln.

Dabei modelliert das statische Modell den eingeschwungenen Zustand des Energieversorgungsnetzes, während das dynamische Modell zusätzlich Schaltvorgänge von z.B. Leistungsschaltern modellieren kann. Das transiente Modell ist von den drei Modellen das genaueste, da das transiente Modell die Prozessgrößen des Energieversorgungsnetzes auch bei Schaltvorgängen mit einem exakten Zeitverhalten modelliert.

Die Schutzeinrichtung schützt das Energieversorgungsnetzes oder genauer den der Schutzeinrichtung zugeordneten Bereich des Energieversorgungsnetzes, in dem die Schutzeinrichtung bei Erfassen eines Fehlers in dem Energieversorgungsnetzes einen Schaltbefehl ausgibt. Der Schaltbefehl wird an einen der Schutzeinrichtung zugeordneten Leistungsschalter übertragen, welcher bei Empfang dieses Schaltbefehls eine Hochspannungsleitung oder einen Teil des Energieversorgungsnetzes unterbricht, um dadurch den von der Schutzeinrichtung geschützten Bereich des Energieversorgungsnetzes vor den Auswirkungen des Fehlers zu schützen.

Zur Überwachung des Energieversorgungsnetzes erfasst die Schutzeinrichtung Prozessgrößen des Energieversorgungsnetzes, wie beispielsweise einen in einer Hochspannungsleitung fließenden Strom oder eine zwischen zwei Hochspannungsleitungen herrschende Hochspannung. Dazu wird die Spannung oder der Strom vorteilhafterweise mit Hilfe eines mit dem Energieversorgungsnetzes der jeweiligen Schutzeinrichtung verbundenen Wandlers gewandelt, so dass die Schutzeinrichtung die Prozessgrößen in Form einer vergleichsweise geringen Spannung (z. B. 100 V) und/oder in Form eines vergleichsweise geringen Stroms (z. B. 1 A) überwachen kann. Darüber hinaus existieren alternative Wandler (z.B. Rogowski-Wandler), welche die Hochspannung und/oder den Starkstrom direkt in Kleinsignale (mV-Bereich) oder Digitalsignale wandeln, die dann von der angeschlossenen Schutzeinrichtung überwacht werden. Abhängig von den derart gewandelten Prozessgrößen bestimmt die Schutzeinrichtung, ob ein Fehler in dem Energieversorgungsnetz vorliegt. Dabei liegt der Fehler beispielsweise vor, wenn der Strom über einen Stromschwellenwert ansteigt oder wenn die Spannung unter einen Spannungsschwellenwert abfällt.

Dabei kann die Prüfsequenz der zu überprüfenden Schutzeinrichtung in Form von Kleinsignalen, Digitalsignalen (z.B. über eine Netzwerkverbindung (z.B. LAN)) (nach IEC 61850-9-2) eingespeist bzw. vorgegeben werden. Es ist aber auch möglich, dass die Prüfsequenz in Form der klassischen Analogsignale (Volt-Bereich) vorgegeben wird.

Darüber hinaus ist es möglich, dass eine der Schutzeinrichtungen über einen Kommunikationskanal mit einer niedrigen Latenzzeit (beispielsweise über einen auf der Hochspannungsleitung mitgeführten Lichtwellenleiter) mit einer anderen der Schutzeinrichtungen in einer Kommunikationsverbindung steht. Dadurch können diese beiden Schutzeinrichtungen Informationen (z. B. Prozessgrößen, Fehlerzustände oder (bevorstehende) Schaltbefehle) von der jeweils anderen Schutzeinrichtung nahezu in Echtzeit erfassen. Abhängig von diesen Informationen kann die jeweilige Schutzeinrichtung entscheiden, ob bei Auftreten oder Vorhandensein eines Fehlers in dem Energieversorgungsnetz der Fehler von der jeweiligen Schutzeinrichtung isoliert wird oder nicht.

Wenn beispielsweise eine Schutzeinrichtung anhand der von ihr erfassten Prozessgrößen einen Fehler detektiert und gleichzeitig anhand der ihr über den Kommunikationskanal übermittelten Informationen erfährt, dass dieser Fehler auch von einer anderen Schutzeinrichtung erfasst worden ist, kann die Schutzeinrichtung beispielsweise das Öffnen des ihr zugeordneten Leistungsschalters verzögern, um abzuwarten, ob der Fehler von der anderen Schutzeinrichtung isoliert werden kann.

Die vorliegende Erfindung kann auch eine Prüfung umfassen, bei welcher der vorab beschriebene Kommunikationskanal zwischen den Schutzeinrichtungen absichtlich unterbrochen wird, um das so genannte Backup-Verhalten bzw. den Reserve-Schutz (d.h. das Schutzverhalten ohne Kommunikationskanal) der Schutzeinrichtungen zu überprüfen.

Vorteilhafterweise wird das erfindungsgemäße Verfahren automatisch von einer zentralen Steuereinrichtung ausgeführt, welche beispielsweise über Prüfeinrichtungen mit jeder zu prüfenden Schutzeinrichtung in Kommunikationsverbindung steht.

Indem die örtlich verteilten Prüfeinrichtungen jeweils mit der zentralen Steuereinrichtung in einer Kommunikationsverbindung stehen, kann zum einen vorteilhafterweise jede Prüfeinrichtung von der Steuereinrichtung gesteuert und kontrolliert werden. Zum anderen sind die Prüfergebnisse aller Schutzeinrichtungen, welche von der jeweiligen Prüfeinrichtung erfasst werden, zentral in der Steuereinrichtung verfügbar.

Gemäß einer weiteren erfindungsgemäßen Ausführungsform kann eine Sequenz von Ausgabeschritten vorgegeben werden. Dabei definiert oder umfasst jeder dieser Ausgabeschritte eine oder mehrere Eingaben oder Prüfgrößen. Unter einer Eingabe bzw. Prüfgröße wird dabei zumindest ein Element aus folgender Gruppe verstanden:
- Eine Eingabe in Form von Prozessgrößen (z. B. Strom, Spannung) des Energieversorgungsnetzes für eine Schutzeinrichtung.
- Ein Zustand (z.B. Schaltzustand) eines Leistungsschalters, ein Zustand (z.B. Schaltzustand) eines Trenners oder eine andere an einen Binäreingang der Schutzeinrichtung angeschlossene binäre Prozessgröße.
- Informationen oder Daten, welche von einer Schutzeinrichtung über einen Kommunikationskanal an eine andere Schutzeinrichtung gesendet werden.

Die Ausgabenschritte werden als die Prüfsequenz an die Schutzeinrichtungen ausgegeben. Dabei wird eine Reihenfolge, in welcher die Ausgabeschritte an die Schutzeinrichtungen ausgegeben werden, von so genannten Triggerereignissen bestimmt. Mit anderen Worten gibt die Reihenfolge, in welcher Triggerereignisse eintreten, die Reihenfolge vor, in welcher die Ausgabenschritte als Prüfsequenz an die Schutzeinrichtungen ausgegeben werden. Dabei kann jedes der Triggerereignisse abhängig von mindestens einem Ereignis aus einer Ereignisgruppe gebildet werden, wobei die Ereignisgruppe folgende Ereignisse umfasst:
- Ein Ereignis, welches bei Ablauf einer vordefinierten Zeitspanne eintritt.
- Ein Ereignis, welches beim Eintreffen eines bestimmten Datums, welches von einer Schutzeinrichtung über einen Kommunikationskanal an eine andere Schutzeinrichtung gesendet wird, eintritt.
- Ein Ereignis, welches eintritt, wenn sich ein bestimmter Leistungsschalter öffnet.
- Ein Ereignis, welches eintritt, wenn sich ein bestimmter Leistungsschalter schließt.
- Ein sonstiges Ereignis, welches (z.B. bei einer vordefinierten Änderung einer Prozessgröße) eintritt und von der Prüfeinrichtung durch die Auswertung der binären Eingänge detektiert werden kann.

Dabei kann das Eintreten eines bestimmten Triggerereignisses zum sofortigen Abbruch des aktuellen Ausgabeschrittes oder zu einem verzögerten Abbruch des aktuellen Ausgabeschrittes führen. Nach dem Abbruch des aktuellen Ausgabeschrittes wird ein von dem jeweiligen Triggerereignis abhängiger Ausgabeschritt aktiviert. Dabei ist es auch möglich, dass die Ausgabeschritte eine vordefinierte Reihenfolge aufweisen und nach dem Abbruch des aktuellen Ausgabeschrittes der gemäß dieser Reihenfolge folgende Ausgabeschritt aktiviert wird, wenn durch das auslösende Triggerereignis kein anderer Ausgabeschritt definiert wird. Der dem aktuellen Ausgabeschritt folgende Ausgabeschritt kann entweder nur von dem aktuellen Ausgabeschritt (in diesem Fall bestimmt ein Triggerereignis den Zeitpunkt des Übergangs vom aktuellen auf den folgenden Ausgabeschritt), nur von dem vorliegenden Triggerereignis oder sowohl von dem aktuellen Ausgabeschritt als auch von dem vorliegenden Triggerereignis abhängig sein.

Mit anderen Worten werden beim Eintreten eines bestimmten Triggerereignisses die Prüfgrößen oder Eingaben, mit welchen die Schutzeinrichtungen gemäß dem aktuellen Ausgabeschritt beaufschlagt werden, sofort oder verzögert durch die Prüfgrößen oder Eingaben ersetzt, welche durch den nächsten Ausgabeschritt definiert sind, welcher abhängig von dem vorliegenden Triggerereignis dem abgebrochenen Ausgabeschritt folgt.

Ein Triggerereignis kann dabei vorliegen, wenn genau ein Ereignis aus der oben genannten Ereignisgruppe vorliegt. Beispielsweise kann ein Triggerereignis eintreten, wenn ein Leistungsschalter geschlossen wird, während ein anderes Triggerereignis eintreten kann, wenn derselbe Leistungsschalter geöffnet wird. Es ist allerdings auch möglich, dass ein bestimmtes Triggerereignis durch die logische Verknüpfung von mehreren Ereignissen definiert wird. Beispielsweise kann ein Triggerereignis vorliegen, wenn zwei (oder mehr) Leistungsschalter jeweils schließen (logisches UND), während ein anderes Triggerereignis vorliegen kann, wenn zumindest einer von zwei (oder mehr) Leistungsschaltern schließt (logisches ODER).

Gemäß der weiteren Ausführungsform werden die Eingaben für die Schutzeinrichtungen insbesondere nicht nur abhängig von den Ausgaben der Schutzeinrichtungen erstellt, sondern die Eingaben können sich auch nach Ablauf einer vorbestimmten Zeitspanne (unabhängig von den Ausgaben) verändern.

Bei der hier beschriebenen weiteren Ausführungsform erfolgt das Generieren der Eingaben für die Schutzeinrichtungen abhängig von den Ausgaben der Schutzeinrichtungen anhand der vorgegebenen Ausgabeschritte, während die Eingaben bei den vorab beschriebenen Ausführungsformen beispielsweise anhand eines Modells des Energieversorgungsnetzes abhängig von den Ausgaben bestimmt werden. Damit ist bei dieser weiteren Ausführungsform im Gegensatz zu der auf einer Netzwerksimulation (d.h. auf dem Modell des Energieversorgungsnetzes) basierenden Erstellung von Eingaben auch ein Zustandswechsel möglich, welcher in der Realität nicht auftreten würde. Dies eröffnet vorteilhafterweise zusätzliche Möglichkeiten, in dem relativ einfach bestimmte Fehlerszenarien getestet werden können, welche in der Realität nur sehr schwer (wenn überhaupt) zu erzeugen sind.

Auch bei dieser Ausführungsform beeinflusst die Reaktion einer einzelnen oder mehrerer Schutzeinrichtungen die Erstellung der endgültigen Prüfsequenz. Darüber hinaus verhindern mögliche Latenzzeiten auf der Kommunikationsverbindung zwischen den Prüfeinrichtungen eine herkömmliche Erstellung der endgültigen Prüfsequenz ohne Rekursion. Mit anderen Worten wird die vorliegende Erfindung auch dann zur Erstellung der endgültigen Prüfsequenz und damit zum Prüfen mehrerer räumlich verteilter Schutzeinrichtungen benötigt, wenn die Eingaben für die Schutzeinrichtungen mit Hilfe der vorgegebenen Ausgabeschritte abhängig von den Ausgaben der Schutzeinrichtungen gewonnen werden (wie es die weitere Ausführungsform beschreibt).

Insbesondere wird die initiale Prüfsequenz gemäß der weiteren Ausführungsform ohne Ereignisse oder Triggerereignisse (d.h. ohne Schaltreaktionen von Leistungsschaltern) an die Schutzeinrichtungen ausgegeben. Anschließend werden die Reaktionen der Schutzeinrichtungen auf die (initiale) Prüfsequenz ausgewertet und die entsprechenden Triggerereignisse berechnet, mit welchen dann weitere Eingaben für die Schutzeinrichtungen erstellt werden, wodurch die Prüfsequenz erweitert wird. Diese erweiterte Prüfsequenz wird erneut an die Schutzeinrichtungen ausgegeben, was dann zu weiteren Triggerereignissen führen kann. Diese Schleife wird solange wiederholt, bis keine weiteren relevanten Ausgaben der Schutzeinrichtungen erfasst werden, welche zu einer weiteren Anpassung der Prüfsequenz führen würden.

Im Rahmen der vorliegenden Erfindung wird auch ein Prüfsystem bereitgestellt, mit welchem mehrere an räumlich verteilten Standorten (z.B. Umspannwerken) angeordnete Schutzeinrichtungen eines Energieversorgungsnetzes geprüft bzw. getestet werden. Dabei umfasst das Prüfsystem eine Steuereinrichtung und mehrere Prüfeinrichtungen. An jedem Standort der Schutzeinrichtungen ist dabei mindestens eine der Prüfeinrichtungen vorhanden. Die Steuereinrichtung besitzt zu jeder dieser Prüfeinrichtungen eine Kommunikationsverbindung. Die jeweilige Prüfeinrichtung ist ausgestaltet, um eine oder mehrere Schutzeinrichtungen zu prüfen, welche an demselben Standort wie die jeweilige Prüfeinrichtung vorhanden sind. Darüber hinaus ist das Prüfsystem zur Durchführung des erfindungsgemäßen Verfahrens ausgestaltet.

Die Vorteile des erfindungsgemäßen Prüfsystems entsprechen den Vorteilen des erfindungsgemäßen Verfahrens, welche vorab im Detail ausgeführt worden sind, so dass hier auf eine Wiederholung verzichtet wird.

Die Steuereinrichtung kann dabei mit einer der Prüfeinrichtungen integriert sein, so dass die Steuereinrichtung und die entsprechende Prüfeinrichtung in derselben Einrichtung integriert sind.

Darüber hinaus wird eine Steuereinrichtung für ein Prüfsystem zum Prüfen von mehreren räumlich verteilten Schutzeinrichtungen eines Energieversorgungsnetzes bereitgestellt. Dabei ist die Steuereinrichtung ausgestaltet, um mit mehreren Prüfeinrichtungen über entsprechende Kommunikationsverbindungen (z.B. Internet, Telefonnetz) zu kommunizieren, welche jeweils einer oder mehreren Schutzeinrichtungen zugeordnet sind. Jede dieser Prüfeinrichtungen ist dabei ausgestaltet, um eine oder mehrere Schutzeinrichtungen zu prüfen. Die Steuereinrichtung selbst ist ausgestaltet, um das erfindungsgemäße Verfahren auszuführen.

Bei der Kommunikationsverbindung, mit welcher die Prüfeinrichtungen mit der Steuereinrichtung kommunizieren, kann es sich auch um eine langsame Verbindung mit einer hohen Latenzzeit (beispielsweise um ein Mobilfunknetz, UMTS) handeln, da die vorliegende Erfindung vorteilhafterweise bezüglich dieser Kommunikationsverbindung keine Echtzeit-Anforderungen stellt.

Des Weiteren beschreibt die vorliegende Erfindung ein Computerprogrammprodukt, insbesondere ein Computerprogramm oder eine Software, welche man in einen Speicher einer programmierbaren Steuerung bzw. eines Computers laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuerung oder in dem Computer läuft. Dabei benötigt das Computerprogrammprodukt eventuell Programmmittel, z.B. Bibliotheken und Hilfsfunktionen, um die entsprechenden Ausführungsformen der Verfahren zu realisieren. Mit anderen Worten soll mit dem auf das Computerprogrammprodukt gerichteten Anspruch insbesondere ein Computerprogramm oder eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert (übersetzt) und gebunden oder der nur interpretiert werden muss, oder um einen ausführbaren Softwarecode handeln, der zur Ausführung nur noch in die entsprechende Recheneinheit (Computer) zu laden ist.

Im Folgenden soll die vorliegende Erfindung nochmals unter einem anderen Blickwinkel dargestellt werden.

Die vorliegende Erfindung testet oder prüft mehrere räumlich verteilte Schutzeinrichtungen eines Energieversorgungsnetzes. Dabei werden insbesondere durch ein entsprechendes Modell des Energieversorgungsnetzes Prozessgrößen an den Einbauorten der zu prüfenden Schutzeinrichtungen berechnet und mit Hilfe der Prüfeinrichtungen den Schutzeinrichtungen zum Testen vorgegeben. Somit werden der Normalbetrieb, Fehlerzustände und Abschaltzustände modelliert bzw. simuliert, so dass die Schutzeinrichtungen bei unterschiedlichen Betriebsarten und Zuständen des Systems (Energieversorgungsnetzes einschließlich Schutzeinrichtungen) geprüft werden. Das verwendete Modell zur Berechnung der Prozessgrößen hat dabei zum einen Einfluss auf die genauen Werte der Prozessgrößen und zum anderen Einfluss auf den Verlauf der Prozessgrößen, wie sie beispielsweise beim Eintritt eines Fehlers oder beim schalten der Leistungsschalter auftreten.

Dazu muss folgendes Problem gelöst werden. Die Verzögerungszeiten, welche bei einer Übertragung eines Schaltvorgangs für einen Leistungsschalter über das Kommunikationsnetz (z.B. Internet, Telefonnetz) auftreten, über welches die Prüfeinrichtungen mit der Steuereinrichtung verbunden sind, überschreiten die Ausbreitungsgeschwindigkeit der Auswirkungen des Schaltvorgangs über das Energieversorgungsnetzes bei weitem. Die vorliegende Erfindung löst dieses Problem, indem die Prüfsequenz schrittweise aufgebaut oder erweitert wird. Dabei wird von der Prämisse ausgegangen, dass sich die jeweilige Schutzeinrichtung deterministisch verhält, so dass die jeweilige Schutzeinrichtung (einschließlich des zugeordneten Leistungsschalters) beim wiederholten Anlegen derselben Prüfgrößen innerhalb gewisser Toleranzen ein identisches Verhalten (beispielsweise beim Ausgeben von Schaltbefehlen) zeigt.

Zur Durchführung der vorliegenden Erfindung versorgen die Prüfeinrichtungen insbesondere analoge Strom-/Spannungs-Eingänge der Schutzeinrichtungen mit entsprechenden Prüfgrößen bzw. Eingaben. Zur Prüfung kann es auch hilfreich sein, wenn bestimmte Binäreingänge der Schutzeinrichtungen, mit welchen beispielsweise Schalterstellungen von Leistungsschaltern signalisiert werden, mit entsprechenden Prüfgrößen bzw. Eingaben versorgt werden.

Gegenüber dem Stand der Technik bietet die vorliegende Erfindung folgende Vorteile:
- Die Ergebnisse der Tests aller Schutzeinrichtungen sind insbesondere auf der zentralen Steuereinrichtung verfügbar und können daher zentral ausgewertet werden.
- Da auch die Reaktion des Energieversorgungsnetzes auf Schaltbefehle bei der Prüfung der Schutzeinrichtungen berücksichtigt wird, erfolgt insbesondere eine Rückkopplung zwischen dem zu prüfenden System (Energieversorgungsnetz mit Schutzeinrichtungen) und dem für die Prüfung verwendeten Modell des Systems.
- Bei der Prüfung können alle Ausgaben der Schutzeinrichtungen insbesondere auch Wiedereinschaltbefehle für Leistungsschalter) berücksichtigt werden.
- Die erfindungsgemäße Prüfung prüft auch ein korrektes Verhalten des Systems hinsichtlich von Zyklen von Öffnen und Wieder-Schließen von Leistungsschaltern, so dass durch falsche Einstellungen der verschiedenen Schutzeinrichtungen auftretende Diskrepanzen und ein nichtsynchrones Systemverhalten bei der Prüfung berücksichtigt wird und gegebenenfalls zu einem negativen Ergebnis der Prüfung führt.

Die vorliegende Erfindung eignet sich zur Durchführung von Tests von Schutzeinrichtungen, mit welchen ein Energieversorgungsnetz geschützt wird. Selbstverständlich ist die vorliegende Erfindung nicht auf diesen bevorzugten Anwendungsbereich eingeschränkt, da mit der vorliegenden Erfindung auch Schutzeinrichtungen getestet werden können, welche gerade hergestellt oder gewartet worden sind.

Die vorliegende Erfindung wird nachfolgend näher unter Bezugnahme auf die beigefügte Zeichnung anhand bevorzugter erfindungsgemäßer Ausführungsformen erläutert.
In Fig. 1 ist ein erfindungsgemäßes Prüfsystem zusammen mit einem Energieversorgungsnetz, welches von zwei Schutzeinrichtungen geschützt wird, dargestellt.
Fig. 2 zeigt einen Flussplan eines erfindungsgemäßen Verfahrens.

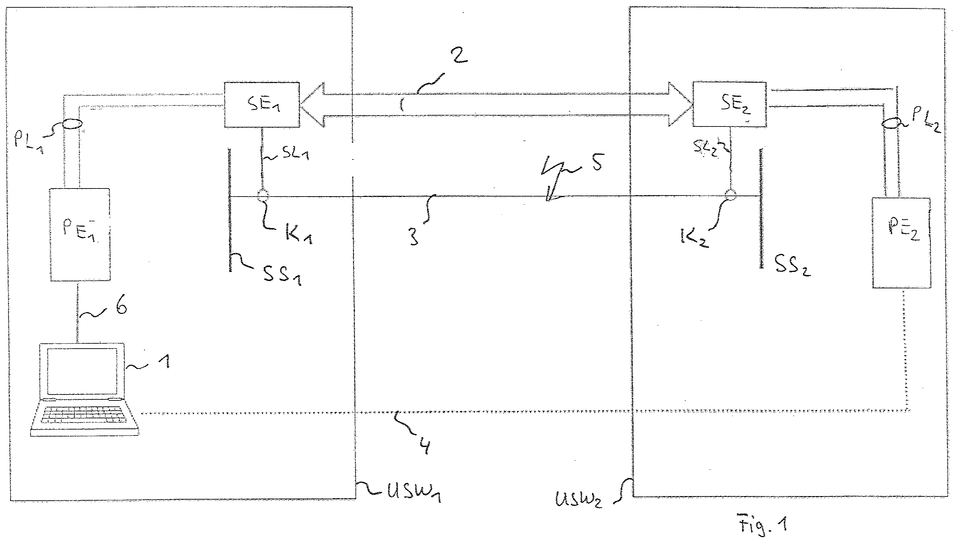

In Fig. 1 ist ein Energieversorgungsnetz in Form einer einzelnen Freileitung 3 dargestellt. Erfindungsgemäß kann ein Energieversorgungsnetz mehrere Freileitungen, andere Hochspannungsleitungen, parallele Leitungen und Transformatoren umfassen, welche netzartig verbunden sind. Die Freileitung 3 endet an beiden Enden jeweils an einer Sammelschiene SS₁, SS₂ in unterschiedlichen Umspannwerken UW₁, UW₂. Innerhalb des jeweiligen Umspannwerks befindet sich jeweils ein Leistungsschalter, mit welchem die elektrische Verbindung zwischen dem die beiden Umspannwerke UW₁, UW₂ verbindenden Teil der Freileitung 3 und der jeweiligen Sammelschiene SS₁, SS₂ unterbrochen werden kann. Darüber hinaus befindet sich innerhalb des jeweiligen Umspannwerks UW₁, UW₂ jeweils ein Wandler, mit welchem ein von der Freileitung 3 geführter Starkstrom (Phasenstrom) und eine an der Freileitung 3 anliegende Hochspannung gewandelt wird, wobei das Ergebnis dieser Wandlung in Form eines Stroms und einer Spannung geringerer Amplitude (z.B. 1 A und 100 V) als Prozessgrößen der jeweiligen Schutzeinrichtung zugeführt werden. Anhand dieser Prozessgrößen überwacht die jeweilige Schutzeinrichtung das Energieversorgungsnetz bzw. die Freileitung 3. Die Stelle, an welcher sich der jeweilige Leistungsschalter und der jeweilige Wandler befinden, ist in Fig. 1 mit K₁ bzw. K₂ bezeichnet.

Bei Auftreten eines Fehlers 5 (beispielsweise eines Kurzschlusses) der Freileitung 3 erfasst die jeweilige Schutzeinrichtung SE₁; SE₂ diesen Fehler 5 anhand der Prozessgrößen, indem beispielsweise der Strom über einen Stromschwellenwert ansteigt oder die Spannung unter einen Spannungsschwellenwert fällt. Sobald die jeweilige Schutzeinrichtung SE₁; SE₂ den Fehler 5 erfasst, gibt sie einen Schaltbefehl an den ihr zugeordneten Leistungsschalter aus, um die elektrische Verbindung zu unterbrechen und damit den Fehler 5 zu isolieren. Nach einer vorbestimmten Pausenzeit nach Erfassen des Fehlers 5 gibt die jeweilige Schutzeinrichtung SE₁; SE₂ einen Schaltbefehl an den ihr zugeordneten Leistungsschalter aus, um die elektrische Verbindung wiederherzustellen. Wenn der Fehler 5 zu diesem Zeitpunkt noch existiert, erfasst dies die jeweilige Schutzeinrichtung SE₁; SE₂ anhand der ihr zugeführten Prozessgrößen der Freileitung 3 und gibt einen weiteren Schaltbefehl, um die elektrische Verbindung mit dem ihr zugeordneten Leistungsschalter wieder zu unterbrechen.

Darüber hinaus sind die beiden Schutzeinrichtungen über einen Kommunikationskanal 2 kommunikationstechnisch verbunden. Über diesen Kommunikationskanal 2 können sich die beiden Schutzeinrichtungen SE₁, SE₂ bestimmte Informationen (z. B. Prozessgrößen, Schaltbefehle) nahezu in Echtzeit übertragen.

Zum Test der Schutzeinrichtungen SE₁, SE₂ existiert in jedem Umspannwerk UW₁, UW₂ eine Prüfeinrichtung PE₁, PE₂, wobei die jeweilige Prüfeinrichtung PE₁, PE₂ mittels einer Prüfleitung PL₁, PL₂ mit der im selben Umspannwerk UW₁, UW₂ angeordneten Schutzeinrichtung SE₁; SE₂ verbunden ist. Darüber hinaus existiert eine zentrale Steuerung 1, welche über eine Kommunikationsleitung 6 und eine WAN-Kommunikationsverbindung 4 mit beiden Prüfeinrichtungen PE₁, PE₂ verbunden ist.

Die Prüfeinrichtungen PE₁, PE₂ sind jeweils mit einer sehr genau gehenden Uhr ausgerüstet, wobei die Uhren der Prüfeinrichtungen PE₁, PE₂ meist mittels GPS synchronisiert werden, um exakt dieselbe Uhrzeit aufzuweisen. Zeitsynchrone Uhren sind beim Anlegen der Prüfsequenz und beim Erfassen der Ausgaben der einzelnen Schutzeinrichtungen SE₁, SE₂ von großer Bedeutung.

Zur Prüfung der Schutzeinrichtungen SE₁, SE₂ werden die Schutzeinrichtungen SE₁, SE₂ von dem Energieversorgungsnetz 3 getrennt, indem die Steuerleitungen SL₁, SL₂ unterbrochen werden. Während der Prüfung erhalten die Schutzeinrichtungen SE₁; SE₂ die von ihnen normalerweise über den Wandler erfassten Prozessgrößen über die jeweilige Prüfleitung PL₁; PL₂ und geben die im Normalbetrieb über die Steuerleitung SL₁, SL₂ ausgegebenen Schaltbefehle über diese Prüfleitung PL₁; PL₂ aus. Das Energieversorgungsnetz wird also während der Prüfung von den Schutzeinrichtungen SE₁, SE₂ nicht geschützt, aber auch nicht durch die Prüfung initiierte Schaltbefehle gestört.

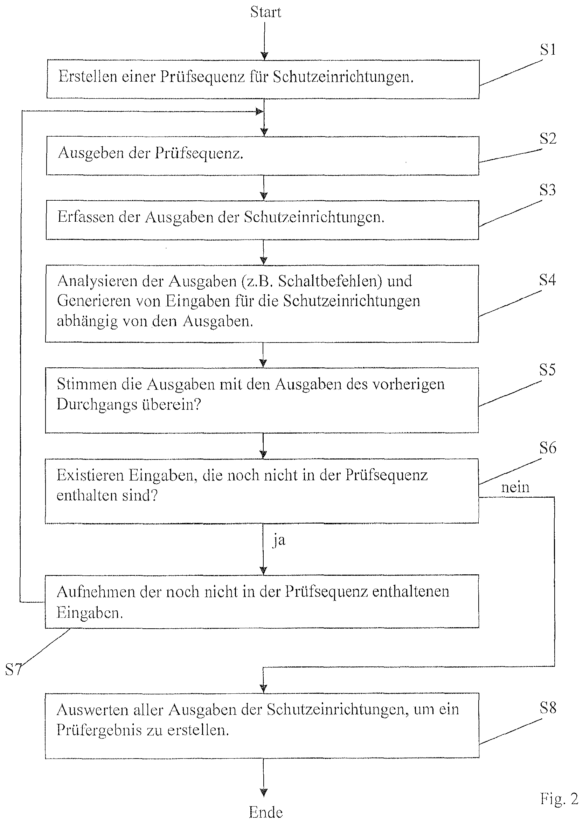

In Fig. 2 ist ein Flussplan eines erfindungsgemäßen Verfahrens zum Prüfen von mehreren räumlich verteilten Schutzeinrichtungen SE₁, SE₂ eines Energieversorgungsnetzes dargestellt.

Im Schritt S1 wird eine Prüfsequenz für eine, mehrere oder alle zu prüfenden Schutzeinrichtungen SE₁, SE₂ erstellt. Mit dieser Prüfsequenz soll überprüft werden, ob sich die jeweilige Schutzeinrichtung SE₁; SE₂ beim Übergang vom Normalbetrieb in einen Fehlerzustand (d.h. die jeweilige Schutzeinrichtung SE₁; SE₂ erfasst einen Fehler im Energieversorgungsnetz) korrekt verhält. Dazu werden die jeweiligen Schutzeinrichtungen SE₁, SE₂ über die Prüfleitung PL₁; PL₂ Prozessgrößen zugeführt, welche im Fehlerfall vom Energieversorgungsnetz bzw. von der Freileitung 3 erfasst würden.

Im Schritt S2 wird die Prüfsequenz von der Steuereinrichtung 1 an die Prüfeinrichtungen PE₁, PE₂ verteilt und von diesen Prüfeinrichtungen PE₁, PE₂ zum exakt selben Zeitpunkt an die jeweiligen Schutzeinrichtungen SE₁, SE₂ ausgegeben, indem entsprechende Testmuster der jeweiligen Schutzeinrichtung SE₁; SE₂ über die jeweilige Prüfleitung PL₁; PL₂ zugeführt werden. Die Reaktion der Schutzeinrichtungen SE₁, SE₂ auf diese Testmuster wird im Schritt S3 erfasst, indem die Ausgaben der jeweiligen Schutzeinrichtung SE₁; SE₂ von der jeweiligen Prüfeinrichtung PE₁, PE₂ auf der jeweiligen Prüfleitung PL₁; PL₂ erfasst und mit einem sehr genauen Zeitstempel versehen werden. Diese Ausgaben umfassen beispielsweise Schaltbefehle an den der jeweiligen Schutzeinrichtung SE₁; SE₂ zugeordneten Leistungsschalter.

Im Schritt S4 werden die im vorherigen Schritt S3 erfassten Ausgaben (insbesondere Schaltbefehle) analysiert. Bei dieser Analyse wird überprüft, ob eine Ausgabe einer Schutzeinrichtung SE₁, SE₂ die Prozessgrößen des Energieversorgungsnetzes 3 verändert, was beispielsweise der Fall ist, wenn die Ausgaben einen Schaltbefehl zum Öffnen eines aktuell geschlossenen Leistungsschalters umfassen. Mit Hilfe eines Modells des Energieversorgungsnetzes 3 werden in diesem Fall ausgehend von den im Schritt S3 erfassten Schaltbefehlen die Prozessgrößen an all denjenigen Stellen K₁, K₂ des Energieversorgungsnetzes 3 simuliert, an welchen die Prozessgrößen von den Schutzeinrichtungen SE₁, SE₂ im Normalbetrieb (Nicht-Prüfbetrieb) abgegriffen werden. Aus den derart simulierten Prozessgrößen ergeben sich entsprechende Eingaben für die Schutzeinrichtungen SE₁, SE₂. (Beispielsweise führt ein Schaltbefehl der Schutzeinrichtung SE₁ zum Öffnen des Leistungsschalters bei K₁ und damit zu einer Änderung der Prozessgrößen an der Stelle K₂, was wiederum zur Änderung der über die Prüfleitung PL₂ zugeführten Eingaben der Schutzeinrichtung SE₂ führt.)

Wenn der Schritt S5 zumindest zum zweiten Mal durchlaufen wird, wird im Schritt S5 überprüft, ob die aktuellen Ausgaben innerhalb gewisser Toleranzen (deterministisch) mit den Ausgaben des vorherigen Durchlaufs übereinstimmen. Ein negatives Ergebnis des Schrittes S5 führt nicht unbedingt zu einem negativen Prüfergebnis. Im Normalfall wird das Verfahren bei einem negativen Ergebnis des Schrittes S5 wiederholt, wobei gegebenenfalls die Toleranzen erhöht werden. Die Bewertung des Ergebnisses des Schrittes S5 kann auch manuell erfolgen. In diesem Fall wird das Verfahren nach einem negativen Ergebnis nur dann wiederholt, wenn der die Prüfung beaufsichtigende Techniker zustimmt.

Im Schritt S6 wird überprüft, ob die im vorherigen Schritt S4 erzeugten Eingaben bereits in der Prüfsequenz enthalten sind. Beim ersten Durchlauf des Schrittes S6 wird dies in aller Regel nicht der Fall sein, sofern im Schritt S3 Schaltbefehle erfasst worden sind. Wenn Eingaben existieren, welche noch nicht in der Prüfsequenz enthalten sind, werden diese Eingaben im Schritt S7 in die Prüfsequenz aufgenommen. Anschließend fährt das erfindungsgemäße Verfahren erneut bei Schritt S2 fort. Es handelt sich also um ein rekursives Verfahren.

Bei einem erneuten Durchlauf der Schritte S2 bis S6 wird mit der im letzten Schritt S7 modifizierten Prüfsequenz der Übergang vom Normalbetrieb zum Fehlerzustand und von dort zum Zustand nach von den Schutzeinrichtungen SE₁, SE₂ initiierten Schaltvorgängen der Leistungsschalter geprüft. Dabei wird im Schritt S6 wiederum überprüft, ob im vorherigen Schritt S4 Ausgaben (insbesondere Schaltbefehle) vorliegen, welche beim vorherigen Durchlauf noch nicht vorlagen. Dies ist beispielsweise der Fall, wenn eine der Schutzeinrichtungen SE₁, SE₂ einen Schaltbefehl zum Wieder-Schließen des ihr zugeordneten Leistungsschalters ausgibt.

Das Verfahren durchläuft die Schritte S2 bis S6 so lange, bis die Schutzeinrichtungen SE₁, SE₂ keine weiteren bzw. neuen Ausgaben (insbesondere Schaltbefehle) ausgeben. Wenn dies der Fall ist, verzweigt das Verfahren zum Schritt S8, in welchem die Ausgaben der Schutzeinrichtungen SE₁, SE₂, welche von den entsprechenden Prüfeinrichtungen erfasst wurden, ausgewertet werden, um ein Prüfergebnis zu erstellen.

In der Regel umfasst die Aufnahme weiterer Eingaben in die Prüfsequenz auch die Aufnahme von Soll-Ausgaben, welche von den Schutzeinrichtungen SE₁, SE₂ aufgrund der neu aufgenommenen Eingaben auszugeben sind. Auch aus diesem Grund ist es möglich, dass beispielsweise im Schritt S4 jeweils bei der Analyse der Ausgaben überprüft wird, ob die jeweils von den Prüfeinrichtungen PE₁, PE₂ erfassten Ausgaben der Schutzeinrichtungen SE₁, SE₂ korrekt sind oder ob bereits ein Fehlverhalten der Schutzeinrichtungen SE₁, SE₂ erfasst wurde, was zu einem negativen Prüfergebnis und damit zu einem vorzeitigen Abbruch der Prüfung führen könnte.

Darüber hinaus kann bei jedem weiteren Durchlauf der Schritte S2 bis S6 verifiziert werden, ob die Ausgaben der Schutzeinrichtungen SE₁, SE₂ den Ausgaben der Schutzeinrichtung SE₁ SE₂ in dem jeweils vorherigen Durchlauf entsprechen, ob also insbesondere jeweils die gleichen Schaltbefehle ausgegeben worden sind. Wenn dies nicht der Fall ist, kann die Prüfung ebenfalls mit einem negativen Ergebnis beendet werden.

### BEZUGSZEICHENLISTE

- 1: Steuerung
- 2: Kommunikationskanal
- 3: Freileitung
- 4: WAN-Kommunikationsverbindung
- 5: Fehler
- 6: Kommunikationsleitung
- K₁, K₂: Knoten (Leistungsschalter und Wandler)
- PE₁, PE₂: Prüfeinrichtung
- PL₁ , PL₂: Prüfleitung
- SL₁, SL₂: Steuerleitung
- S1-S8: Verfahrensschritt
- SS₁, SS₂: Sammelschiene
- USW₁, USW₂: Umspannwerk

## Patentansprüche

1. Verfahren zum Prüfen mehrerer räumlich verteilter Schutzeinrichtungen (SE₁, SE₂) eines Energieversorgungsnetzes (3),
wobei jede der Schutzeinrichtungen (SE₁, SE₂) ausgestaltet ist, um bei Auftreten eines Fehlers (5) in dem Energieversorgungsnetz (3) den Fehler (5) im Energieversorgungsnetz (3) zu isolieren,
wobei das Verfahren folgende Schritte in einer Steuereinrichtung umfasst:
a: Erstellen einer initialen Prüfsequenz,
b: Ausgeben der Prüfsequenz an die Schutzeinrichtungen (SE1, SE2),
c: Erfassen von Ausgaben der Schutzeinrichtungen (SE1, SE2), welche die Schutzeinrichtungen (SE1, SE2) aufgrund der Prüfsequenz ausgeben,
d: Analysieren der Ausgaben und Generieren von Eingaben für die Schutzeinrichtungen (SE1, SE2) abhängig von den Ausgaben,
wobei, wenn die Eingaben nicht Bestandteil der Prüfsequenz sind, diese Eingaben in die Prüfsequenz aufgenommen werden und mit Schritt b fortgesetzt wird, während ansonsten mit Schritt e fortgesetzt wird, und
e: Auswerten aller Ausgaben der Schutzeinrichtungen (SE1, SE2),
wobei die Prüfsequenz Eingaben in Form von Prozessgrößen des Energieversorgungsnetzes (3) für mindestens eine der Schutzeinrichtungen (SE₁, SE₂) und Soll-Ausgaben, welche von der jeweiligen geprüften Schützeinrichtung (SE1; SE2) abhängig von den Eingaben ausgegebenen werden sollen, umfasst.

2. Verfahren nach Anspruch 1,
**dadurch gekennzeichnet,**
**dass** die Ausgaben der mindestens einen der Schutzeinrichtungen (SE₁, SE₂) einen Schalteröffnungsbefehl, mit welchem ein Leistungsschalter zur Isolierung des Fehlers (5) geöffnet wird, und/oder einen Wiedereinschaltbefehl, mit welchem eine Isolierung eines Fehlers (5) durch Schließen eines Leistungsschalters wieder aufgehoben wird, umfassen.

3. Verfahren nach Anspruch 1 oder 2,
**dadurch gekennzeichnet,**
**dass** das Generieren der Eingaben abhängig von den Ausgaben erfolgt, indem ausgehend von den Ausgaben anhand eines Modells des Energieversorgungsnetzes (3) Änderungen der Prozessgrößen des Energieversorgungsnetzes (3) bestimmt werden.

4. Verfahren nach Anspruch 3,
**dadurch gekennzeichnet,**
**dass** das Modell ein statisches, ein dynamisches oder ein transientes Modell ist.

5. Verfahren nach einem der vorhergehenden Ansprüche,
**dadurch gekennzeichnet,**
**dass** von jeder Schutzeinrichtung (SE₁, SE₂) bei Auftreten eines Fehlers (5) in dem Energieversorgungsnetz (3) ein Befehl zum Öffnen eines Leistungsschalters ausgegeben wird, um den Fehler (5) zu isolieren.

6. Verfahren nach einem der vorhergehenden Ansprüche,
**dadurch gekennzeichnet,**
**dass** für jede der Schutzeinrichtungen (SE₁, SE₂) die Prozessgrößen des Energieversorgungsnetzes (3) über einen mit dem Energieversorgungsnetz (3) verbundenen Wandler erfasst werden, und
**dass** abhängig von den Prozessgrößen bestimmt wird, ob ein Fehler (5) in dem Energieversorgungsnetz (3) vorliegt.

7. Verfahren nach einem der vorhergehenden Ansprüche,
**dadurch gekennzeichnet,**
**dass** eine der Schutzeinrichtungen (SE₁, SE₂) über einen Kommunikationskanal (2) mit einer anderen der Schutzeinrichtungen (SE₁, SE₂) verbunden ist, dass die Schutzeinrichtung (SE₁, SE₂) über den Kommunikationskanal (2) Informationen von der anderen Schutzeinrichtung (SE₁, SE₂) erfasst, und
**dass** abhängig von den Informationen entschieden wird, ob bei Auftreten eines Fehlers (5) in dem Energieversorgungsnetz (3) der Fehler (5) von der Schutzeinrichtungen (SE₁, SE₂) isoliert wird.

8. Verfahren nach einem der vorhergehenden Ansprüche,
**dadurch gekennzeichnet,**
**dass** das Verfahren automatisch von einer zentralen Steuereinrichtung (1) ausgeführt wird.

9. Verfahren nach einem der vorhergehenden Ansprüche,
**dadurch gekennzeichnet,**
**dass** Ausgabeschritte vorgegeben werden,
**dass** jeder der Ausgabeschritte mindestens eine Eingabe umfasst, und
**dass** die Ausgabeschritte als die Prüfsequenz an die Schutzeinrichtungen (SE₁, SE₂) in einer von Triggerereignissen abhängigen Reihenfolge ausgegeben werden, wobei jedes Triggerereignis abhängig von zumindest einem Ereignis aus einer Ereignisgruppe ist, wobei die Ereignisgruppe umfasst:
• Ablauf einer vordefinierten Zeitspanne,
• Eintreffen eines bestimmten Datums von einer der Schutzeinrichtungen über einen Kommunikationskanal an eine andere der Schutzeinrichtungen, und
• eine Schalterstellung eines Leistungsschalters wird geändert.

10. Prüfsystem zum Prüfen von mehreren an räumlich verteilten Standorten angeordneten Schutzeinrichtungen (SE₁, SE₂) eines Energieversorgungsnetzes (3),
wobei das Prüfsystem eine Steuereinrichtung (1) und mehrere Prüfeinrichtungen (PE₁, PE₂) umfasst,
wobei an jedem Standort (USW1; USW2) der Schutzeinrichtungen (SE₁, SE₂) mindestens eine der Prüfeinrichtungen (PE₁, PE₂) vorhanden ist,
wobei die Steuereinrichtung (1) eine Kommunikationsverbindung (4; 6) zu jeder der Prüfeinrichtungen (PE₁, PE₂) aufweist,
wobei jede der Prüfeinrichtungen (PE₁, PE₂) zum Prüfen mindestens einer der Schutzeinrichtungen (SE₁, SE₂) ausgestaltet ist, welche am selben Standort (USW1; USW2) wie die jeweilige Prüfeinrichtung (PE₁; PE₂) vorhanden ist, und
wobei das Prüfsystem (1, PE₁, PE₂) ausgestaltet ist, um das Verfahren nach einem der vorhergehenden Ansprüche durchzuführen.

11. Prüfsystem nach Anspruch 10,
**dadurch gekennzeichnet,**
**dass** die Steuereinrichtung (1) in eine der Prüfeinrichtungen (PE₁, PE₂) integriert ist.

12. Steuereinrichtung (1) für ein Prüfsystem zum Prüfen von mehreren räumlich verteilten Schutzeinrichtungen (SE₁, SE₂) eines Energieversorgungsnetzes (3),
wobei die Steuereinrichtung (1) zum Kommunizieren mit mehreren, den Schutzeinrichtungen (SE₁, SE₂) jeweils zugeordneten Prüfeinrichtungen (PE₁, PE₂) ausgestaltet ist,
wobei jede Prüfeinrichtung (PE₁; PE₂) zum Prüfen mindestens einer der Schutzeinrichtungen (SE₁, SE₂) ausgestaltet ist,
wobei die Steuereinrichtung (1) zur Durchführung des Verfahrens nach einem der Ansprüche 1-9 ausgestaltet ist.

13. Computerprogrammprodukt mit darauf gespeicherten computerlesbaren Anweisungen, welche derart ausgestaltet sind, dass bei Ausführung dieser Anweisungen durch einen Computer das Verfahren nach einem der Ansprüche 1-9 ausgeführt wird.

## Claims

1. A method for testing multiple spatially distributed protective devices (SE₁, SE₂) of an energy supply network (3),
wherein each of the protective devices (SE₁, SE₂) is configured in order so as to, in the event of a fault (5) occurring in the energy supply network (3), isolate the fault (5) in the energy supply network (3), wherein the method comprises the following steps in a control device:
a: producing of an initial test sequence,
b: outputting of the test sequence to the protective devices (SE₁, SE₂),
c: detecting outputs of the protective devices (SE₁, SE₂) that the protective devices (SE₁, SE₂) output on the basis of the test sequence,
d: analysing the outputs and generating inputs for the protective devices (SE₁, SE₂) depending on the outputs, wherein, if the inputs are not part of the test sequence, these inputs are incorporated into the test sequence and step b is proceeded with, while otherwise step e is proceeded with, and
e: evaluation of all outputs of the protective devices (SE₁, SE₂),
wherein the test sequence comprises inputs in the form of process variables of the energy supply network (3) for at least one of the protective devices (SE₁, SE₂) and target outputs which are to be outputted by the respective protective device (SE₁, SE₂) depending on the inputs.

2. The method according to claim 1,
**characterised in that**
the outputs of the at least one of the protective devices (SE₁, SE₂) comprise a switch opening command, with which a circuit breaker is opened to isolate the fault (5), and/or a reclose command, with which an isolation of a fault (5) is cancelled again by closing a circuit breaker.

3. The method according to claim 1 or 2,
**characterised in that**
the generating of the inputs takes place depending on the outputs **in that** starting out from the outputs, changes in the process variables of the energy supply network (3) are determined with reference to a model of the energy supply network (3).

4. The method according to claim 3,
**characterised in that**
the model is a static, a dynamic or a transient model.

5. The method according to any one of the preceding claims,
**characterised in that**
upon the occurrence of a fault (5) in the energy supply network (3), a command to open a circuit breaker is outputted by each protective device (SE₁, SE₂) in order to isolate the fault (5).

6. The method according to any one of the preceding claims,
**characterised in that**
for each of the protective devices (SE₁, SE₂) the process variables of the energy supply network (3) are detected via a transformer connected to the energy supply network (3), and
it is determined depending on the process variables whether a fault (5) is present in the energy supply network (3).

7. The method according to any one of the preceding claims,
**characterised in that**
one of the protective devices (SE₁, SE₂) is connected via a communications channel (2) to another of the protective devices (SE₁, SE₂),
the protective device (SE₁, SE₂) acquires information from the other protective device (SE₁, SE₂) via the communications channel (2), and
it is decided depending on the information whether, in the event of a fault (5) occurring in the energy supply network (3), the fault (5) is isolated by the protective devices (SE₁, SE₂).

8. The method according to any one of the preceding claims,
**characterised in that**
the method is executed automatically by a central control device (1).

9. The method according to any one of the preceding claims, **characterised in that** output steps are specified, that each of the output steps comprises at least one input, and that the output steps are outputted as the test sequence to the protective devices (SE₁, SE₂) in an order dependent on trigger events, wherein each trigger event is dependent on at least one event from an event group, wherein the event group comprises:
• expiry of a predetermined timespan,
• arrival of a certain item of data from one of the protective devices via a communications channel at another of the protective devices, and
• a switch setting of a circuit breaker is changed.

10. A testing system for testing multiple spatially distributed protective devices (SE₁, SE₂) of an energy supply network (3),
wherein the testing system comprises a control device (1) and multiple testing devices (PE₁, PE₂),
wherein at least one of the testing devices (PE₁, PE₂) is present at each location (USW₁; USW₂) of the protective devices (SE₁, SE₂),
wherein the control device (1) has a communications connection (4; 6) to each of the testing devices (PE₁, PE₂),
wherein each of the testing devices (PE₁, PE₂) is configured to test at least one of the protective devices (SE₁, SE₂), which is present at the same location (USW₁; USW₂) as the respective testing device (PE₁, PE₂), and
wherein the testing system is configured to execute the method according to any one of the preceding claims.

11. The testing system according to claim 10,
**characterised in that**
the control device is integrated into one of the testing devices (PE₁, PE₂).

12. A control device (1) for a testing system for testing multiple spatially distributed protective devices (SE₁, SE₂) of an energy supply network ,
wherein the control device (1) is configured to communicate with multiple testing devices (PE₁, PE₂) assigned respectively to the protective devices (SE₁, SE₂),
wherein each testing device (PE₁, PE₂) is configured to test at least one of the protective devices (SE₁, SE₂),
wherein the control device (1) is configured to execute the method according to any one of claims 1 to 9.

13. A computer program product having programmable instructions stored thereon, which are configured such that the method according to any one of claims 1 to 9 is carried out upon execution of these instructions by a computer.

## Revendications

1. Procédé servant à contrôler plusieurs dispositifs de protection (SE₁, SE₂) répartis spatialement d'un réseau d'alimentation en énergie (3),
dans lequel chacun des dispositifs de protection (SE₁, SE₂) est configuré afin d'isoler, en cas d'apparition d'une anomalie (5) dans le réseau d'alimentation en énergie (3), l'anomalie (5) dans le réseau d'alimentation en énergie (3),
dans lequel le procédé comprend, dans un dispositif de pilotage, des étapes suivantes consistant à :
a : créer une séquence de contrôle initiale,
b : sortir la séquence de contrôle pour la fournir aux dispositifs de protection (SE₁, SE₂),
c : détecter des sorties des dispositifs de protection (SE₁, SE₂), que les dispositifs de protection (SE₁, SE₂) sortent sur la base de la séquence de contrôle,
d : analyser les sorties et générer des entrées pour les dispositifs de protection (SE₁, SE₂) en fonction des sorties,
dans lequel, quand les entrées ne font pas partie intégrante de la séquence de contrôle, lesdites entrées sont enregistrées dans la séquence de contrôle et on poursuit avec l'étape b, tandis qu'on poursuit sinon avec l'étape e, et
e : évaluer toutes les sorties des dispositifs de protection (SE₁, SE₂),
dans lequel la séquence de contrôle comprend des entrées sous la forme de grandeurs de processus du réseau d'alimentation en énergie (3) pour au moins un des dispositifs de protection (SE₁, SE₂) et des sorties théoriques, qui sont censées être sorties par le dispositif de protection (SE₁ ; SE₂) contrôlé respectivement, en fonction des entrées.

2. Procédé selon la revendication 1,
**caractérisé en ce**
**que** les sorties de l'au moins un dispositif de protection (SE₁, SE₂) comprennent une commande d'ouverture de commutateur, avec laquelle un sectionneur de puissance est ouvert afin d'isoler l'anomalie (5), et/ou une commande de remise en service, avec laquelle un isolement d'une anomalie (5) par la fermeture d'un sectionneur de puissance est annulé à nouveau.

3. Procédé selon la revendication 1 ou 2,
**caractérisé en ce**
**que** la génération des entrées est effectuée en fonction des sorties, en partant des sorties des modifications des grandeurs de processus du réseau d'alimentation en énergie (3) étant déterminées à l'aide d'un modèle du réseau d'alimentation en énergie (3).

4. Procédé selon la revendication 3,
**caractérisé en ce**
**que** le modèle est un modèle statique, un modèle dynamique ou un modèle transitoire.

5. Procédé selon l'une quelconque des revendications précédentes,
**caractérisé en ce**
**qu'**une commande servant à ouvrir un disjoncteur de puissance est sortie par chaque dispositif de protection (SE₁, SE2) en cas d'apparition d'une anomalie (5) dans le réseau d'alimentation en énergie (3) afin d'isoler l'anomalie (5).

6. Procédé selon l'une quelconque des revendications précédentes,
**caractérisé en ce**
**que** les grandeurs de processus du réseau d'alimentation en énergie (3) sont détectées, pour chacun des dispositifs de protection (SE₁, SE₂), par l'intermédiaire d'un convertisseur relié au réseau d'alimentation en énergie (3), et
**qu'**on détermine en fonction des grandeurs de processus la présence éventuelle d'une anomalie (5) dans le réseau d'alimentation en énergie (3).

7. Procédé selon l'une quelconque des revendications précédentes,
**caractérisé en ce**
**qu'**un des dispositifs de protection (SE₁, SE₂) est relié à un autre des dispositifs de protection (SE₁, SE₂) par l'intermédiaire d'un canal de communication (2),
**que** le dispositif de protection (SE₁, SE₂) détecte, par l'intermédiaire du canal de communication (2), des informations de l'autre dispositif de protection (SE₁, SE₂), et
**qu'**on décide en fonction des informations si en cas d'apparition d'une anomalie (5) dans le réseau d'alimentation en énergie (3), l'anomalie (5) est isolée par le dispositif de protection (SE₁, SE₂).

8. Procédé selon l'une quelconque des revendications précédentes,
**caractérisé en ce**
**que** le procédé est exécuté automatiquement par un dispositif de pilotage (1) central.

9. Procédé selon l'une quelconque des revendications précédentes,
**caractérisé en ce**
**que** des étapes de sortie sont spécifiées,
**que** chacune des étapes de sortie comprend au moins une entrée, et
**que** les étapes de sortie sont sorties sous la forme de la séquence de contrôle pour être fournies aux dispositifs de protection (SE₁, SE₂) dans une commande dépendant des événements déclencheurs, dans lequel chaque événement déclencheur dépend d'au moins un événement issu d'un groupe d'événements, dans lequel le groupe d'événements comprend :
- le déroulement d'un laps de temps prédéfini,
- l'arrivée d'une date donnée provenant d'un des dispositifs de protection par l'intermédiaire du canal de communication au niveau d'un autre des dispositifs de protection, et
- la modification d'une position de commutation d'un disjoncteur de puissance.

10. Système de contrôle servant à contrôler plusieurs dispositifs de protection (SE₁, SE₂) disposés en des emplacements répartis spatialement, d'un réseau d'alimentation en énergie (3),
dans lequel le système de contrôle comprend un dispositif de pilotage (1) et plusieurs dispositifs de contrôle (PE₁, PE₂),
dans lequel au moins un des dispositifs de contrôle (PE₁, PE₂) est présent au niveau de chaque emplacement (USW1 ; USW2) des dispositifs de protection (SE₁, SE₂),
dans lequel le dispositif de pilotage (1) présente une liaison de communication (4 ; 6) vers chacun des dispositifs de contrôle (PE₁, PE₂),
dans lequel chacun des dispositifs de contrôle (PE₁, PE₂) est configuré afin de contrôler au moins un des dispositifs de protection (SE₁, SE₂), lequel est présent au niveau du même emplacement (USW1 ; USW2) que le dispositif de contrôle (PE₁ ; PE₂) respectif, et
dans lequel le système de contrôle (1, PE₁, PE₂) est configuré afin de mettre en oeuvre le procédé selon l'une quelconque des revendications précédentes.

11. Système de contrôle selon la revendication 10,
**caractérisé en ce**
**que** le dispositif de pilotage (1) est intégré dans l'un des dispositifs de contrôle (PE₁, PE₂).

12. Dispositif de pilotage (1) pour un système de contrôle servant à contrôler plusieurs dispositifs de protection (SE₁, SE₂) répartis spatialement d'un réseau d'alimentation en énergie (3),
dans lequel le dispositif de pilotage (1) est configuré afin de communiquer avec plusieurs dispositifs de contrôle (PE₁, PE₂) respectivement associés aux dispositifs de protection (SE₁, SE₂),
dans lequel chaque dispositif de contrôle (PE₁ ; PE₂) est configuré afin de contrôler au moins un des dispositifs de protection (SE₁, SE₂),
dans lequel le dispositif de pilotage (1) est configuré afin de mettre en oeuvre le procédé selon l'une quelconque des revendications 1 - 9.

13. Produit de programme informatique comprenant des instructions mémorisées dans ce dernier, pouvant être lus par un ordinateur, lesquelles sont configurées de telle manière qu'en cas d'exécution desdites instructions par un ordinateur, le procédé selon l'une quelconque des revendications 1 - 9 est exécuté.
